# EUROPÄISCHE PATENTSCHRIFT

(11) **EP 2 646 599 B1**
(45) Veröffentlichungstag und Bekanntmachung des Hinweises auf die Patenterteilung: **07.02.2018**
(21) Anmeldenummer: 11817470.5
(22) Anmeldetag: 01.12.2011
(51) Int. Cl.: C23C 28/02, B23K 1/00, C23C 14/14, C23C 14/00, C23C 24/04

(54) **REAKTIVE METALLISCHE SYSTEME UND VERFAHREN ZUM HERSTELLEN VON REAKTIVEN METALLISCHEN SYSTEMEN**
REACTIVE METALLIC SYSTEMS AND METHODS FOR PRODUCING REACTIVE METALLIC SYSTEMS
SYSTÈMES MÉTALLIQUES RÉACTIFS ET PROCÉDÉS DE PRÉPARATION DE SYSTÈMES MÉTALLIQUES RÉACTIFS

(30) Priorität: 01.12.2010 DE 102010060937
(43) Veröffentlichungstag der Anmeldung: 09.10.2013
(73) Patentinhaber: Steinbeis Forschungs- und Innovationszentren GmbH, 70174 Stuttgart (DE)
(72) Erfinder: WOLL, Karsten, 66386 St. Ingbert (DE); MÜCKLICH, Frank, 66773 Schwalbach (DE)
(74) Vertreter: Vièl, Christof
(86) Internationale Anmeldenummer: PCT/DE2011/075295
(87) Internationale Veröffentlichungsnummer: WO 2012/072073

(56) Entgegenhaltungen:
- WO-A1-01/83182
- WO-A1-2011/112647
- WO-A2-01/83205
- WO-A2-2007/095303
- US-A1- 2006 236 887

## Beschreibung

Die Erfindung betrifft die Verwendung eines Verfahrens zur lokalen Wärmeerzeugung.

Reaktive metallische Systeme bestehen aus metallischen Partikeln in Form von Pulvern oder Pasten bzw. aus metallischen Multischichten.

In technischen Anwendungen wird oftmals lokal die kontrollierte Freisetzung von Wärme verlangt. Beispiel ist das Löten bzw. Bonden in der Mikrosystemtechnik. Eine Möglichkeit lokal Wärme zu erzeugen, ist die Verwendung reaktiver metallischer Systeme in Form von metallischen Multischichten. Solche Multischichten bestehen aus übereinander abgeschiedenen, dünnen metallischen Einzelschichten mit Dicken im Nanometerbereich. Die Gesamtdicke der Multischicht kann mehrere zehn µm betragen. Durch lokale Zufuhr von Wärmeenergie, beispielsweise durch einen Laserstrahl oder durch einen Zündfunken, wird dort eine exotherme chemische Reaktion zwischen den metallischen Elementen ausgelöst. Bedingt durch Wärmetransport pflanzt sich diese Reaktion durch die gesamte Multischicht parallel zu den Einzelschichten fort. Die Ausbreitungsgeschwindigkeit kann dabei mehrere m/s betragen. Die entstehende Wärme erhitzt die Multischicht bis auf eine Temperatur, die je nach verwendeter Materialkombination zwischen 1000 °C und 1600 °C variieren kann. Diese Temperatur, bzw. Wärmemenge, wird letztlich in den unterschiedlichen Applikationen ausgenutzt.

Der Einsatz einer solchen lokalen Wärmequelle in Form schnell reagierender Multischichtfolien zur Herstellung von beispielsweise Lotverbindungen minimiert den Wärme- und Spannungseintrag in angrenzende Bauteile. Die Wärme wird direkt im Fügespalt freigesetzt. Diese Methode bietet daher gegenüber dem konventionellen Löten mehrere Vorteile. Zunächst werden keine äußeren Wärmequellen (außer zur Reaktionsinitiierung) benötigt. Außerdem kann der Fügeprozess in einer beliebigen Atmosphäre durchgeführt werden. Besonders signifikant ist der Aspekt einzuschätzen, dass die Temperatur der zu fügenden Bauteile nicht ansteigt. Die Wärmeeinflusszone bei maximaler Temperatur bleibt beim Fügen von Edelstahl auf einen Bereich von einigen zehn µm um die reaktive Dünnschicht beschränkt.

Im Rahmen reaktiver metallischer Multischichten wurden viele Materialkombinationen untersucht. Die Systeme Rh/Si, Ni/Si, Zr/Si sowie Ni/Al, Ti/Al, Monel/Al, and Zr/Al werden in der US 6,736,942 B2 beschrieben, wobei Multischichten auf Ni/Al und Monel®/Al Basis schon kommerziell verfügbar sind. Generell ist vom theoretischen und auch experimentellen Standpunkt aus festzustellen, dass für das System Ni/Al der Kenntnisstand am größten ist.

Wissenschaftlich gehört die beschriebene chemische Reaktion in das Feld der Synthese von Werkstoffen mittels selbstfortschreitender (self-progating) Reaktionen. Solche Reaktionen können sowohl in Pulvern als auch in metallischen Multischichten induziert werden Die Reaktionsprodukte sind intermetallische Phasen. Das Mengenverhältnis der Elementpulver bzw. das Schichtdickenverhältnis der individuellen Schichten legt die Stöchiometrie fest. Letztere wird so eingestellt, daß die Reaktionen möglichst stark exotherm sind und somit viel Wärme freigesetzt wird. Orientierung dafür bieten die Bildungswärmen der unterschiedlichen intermetallischen Phasen. Im System Ni/Al besitzt die B2-Phase NiAl die größte negative Bildungswärme. Für reaktive Multischichten wird beispielsweise ein Schichtdickenverhältnis von Al- zu Ni-Schicht von 1.52 wird für die 1:1 Stöchiometrie eingestellt. Die erreichbaren Temperaturen sind materialabhängig und können Werte weit oberhalb von 1000 °C erreichen. Allerdings weisen die als Reaktionsprodukte entstehenden intermetallischen Phasen eine hohe Sprödigkeit bei Raumtemperatur auf. Letzteres begrenzt die Anwendung vor allem für Applikationen bei Raumtemperatur.

Aus der WO 2007/095303 A2 sind Verzögerungselemente, die reaktive Multischichten aufweisen, Detonatoren, die solche Verzögerungselemente enthalten und ein Herstellungsverfahren hierfür bekannt.

Auch die US 2006/0236887 A1 beschreibt Verzögerungselemente auf der Basis von reaktiven Multischichten, und ein Herstellungsverfahren hierfür.

Freistehende Folien aus reaktiven Multischichten und deren Verwendung sind aus der WO 01/83182 A1 bekannt.

Strukturen auf Grundlage von reaktiven Multischichten werden in der WO 01/83205 A2 beschrieben.

Der Erfindung liegt die Aufgabe zu Grunde, neue Techniken für die Fertigungstechnik zu schaffen.

Diese Aufgabe wird bei einer ersten Ausgestaltung der Erfindung dadurch gelöst, dass in der Fertigungstechnik zum großflächigen Fügen zweier metallischer Flächenelemente sequentiell Ruthenium- bzw. Aluminium-Dünnschichten zur Bildung einer Multischicht übereinander abgeschieden werden, wobei die Einzelschichtdicke der Ruthenium- bzw. der Aluminiumschichten zwischen 10 und 500 nm beträgt und die Multischicht mittels eines Laserstrahls, Zündfunkens oder per offener Flamme lokal erhitzt und eine exotherme Reaktion von Ru und Al zu RuAl induziert wird.

Bei einer zweiten Ausgestaltung der Erfindung wird die Aufgabe dadurch gelöst, dass in der Fertigungstechnik zum großflächigen Fügen zweier metallischer Flächenelemente Pulver, welches Ruthenium- bzw. Aluminium-Partikel enthält, appliziert wird, wobei die Ruthenium- bzw. der Aluminiumpartikel einen mittleren Durchmesser von 10 bis 100 nm aufweisen und das Pulver mittels eines Laserstrahls, Zündfunkens oder per offener Flamme lokal erhitzt und eine exotherme Reaktion von Ru und Al zu RuAl induziert wird.

Es ist auch möglich, dass das Pulver aus Ruthenium- und Aluminiumpartikeln besteht.

Das Pulversystem ist auf Ru/Al-Basis und ist daher (unter anderem oder ausschließlich) aus Ruthenium- und Aluminiumpulver aufgebaut. Alternativ ist das Pulver aus aluminiumbeschichteten Rutheniumpartikeln bzw. rutheniumbeschichteten Aluminiumpartikeln aufgebaut. Die Erfindung erfasst dadurch Reaktionen zwischen zwei Partikeln und innerhalb eines Partikels.

Die vorgelegte Erfindung löst die Aufgabe durch die Wahl des Systems Ru/Al als Grundsystem. Die stärkste exotherme Reaktion und damit die meiste freigesetzte Wärmemenge sind für stöchiometrisch aufgebaute reaktive Systeme zu erwarten. Hier ist die Bildungswärme am größten. Vorteilhaft ist die entstehende intermetallische Phase RuAl. Diese ist im Gegensatz zu vielen vergleichbaren intermetallischen Phasen, wie etwa NiAl, bei Raumtemperatur äußerst duktil.

Die Auswahl von RuAl sei im Folgenden nochmals näher erläutert. Die Standardbildungsenthalpie H_{f} ist ein erster Indikator für die Applikation von reaktiven Multischichten. Sie kategorisiert die metallischen Systeme hinsichtlich der potentiell freisetzbaren Wärmemenge. H_{f} skaliert mit der maximal verfügbaren Wärmemenge. In der Anwendung zeigte sich weiterhin, dass die Raumtemperaturduktilität ein zweiter wichtiger Parameter ist. Letztere wird charakterisiert durch die Spröd-Duktil-Übergangstemperatur T_{BD}. Unterhalb dieser Temperatur ist ein generell sprödes Verhalten zu erwarten. Während des schnellen Abkühlens der Dünnschicht von etwa 1000 °C auf Raumtemperatur innerhalb einiger ms werden extrinsisch Spannungen in der Schicht generiert. Im System NiAl führen diese Spannungen zum Bruch der Schicht. Ursächlich dafür ist die niedrige Duktilität von NiAl bei Raumtemperatur. Darüber hinaus wird die Lotverbindung überwiegend niedrigen Temperaturen um Raumtemperatur ausgesetzt, sodass die mechanischen Raumtemperatureigenschaften mitbestimmend für die Verwendbarkeit des reaktiven metallischen Systems sind.

Es ist zur Erfindung gehörig, dass die Einzelschichtdicke der Ruthenium- bzw. der Aluminiumschichten zwischen 10 und 500 nm beträgt.

Ebenso ist zur Erfindung gehörig, dass die Schichtdicke der Multischicht bis zu 100 µm beträgt.

Im Rahmen der Erfindung liegt auch ein Verfahren zum Herstellen von reaktiven metallischen Systemen, gemäß dem sequentiell Ruthenium- bzw. Aluminium-Dünnschichten auf einem Substrat zur Bildung einer Multischicht übereinander abgeschieden werden, wobei die Einzelschichtdicke der Ruthenium- bzw. der Aluminiumschichten zwischen 10 und 500 nm beträgt.

In diesem Zusammenhang ist es vorteilhaft, dass das Abscheiden der Ruthenium- bzw. Aluminium-Dünnschichten mittels physikalischer oder chemischer Dampfabscheidung erfolgt.

Eine Weiterbildung der Erfindung besteht darin, dass die sequentiell abgeschiedenen Ruthenium- und Aluminium-Dünnschichten als Multischicht von dem Substrat abgehoben werden.

Es liegt dann eine freistehende Multischicht vor, die folienartig ausgebildet ist.

Bei dem erfindungsgemäßen Verfahren ist vorgesehen, dass die Multischicht eine Schichtdicke von bis zu 100 µm aufweist.

Schließlich ist auch zur Erfindung gehörig, dass aus mehreren Multischichten ein Multischichtstapel gebildet wird.

Vorzugsweise weist ein derartiger Multischichtstapel eine Gesamtschichtdicke von bis zu 1 cm auf.

Vorzugsweise weisen die Partikel einen mittleren Durchmesser von 10 bis 100 nm auf.

Es liegt im Rahmen der Erfindung, daß das reaktive metallische System in einer Form vorliegt, die für Dickschichtapplikationen geeignet ist, insbesondere in Pulver-, Pasten- oder Tintenform.

Die erreichten Vorteile durch die vorliegende Erfindung betreffen mehrere Bereiche. Betrachtet man erstens den Sektor des Lötens bzw. Bondings, so ist vor allem zu erwarten, dass, bedingt durch die signifikant gesteigerte Raumtemperaturduktilität der in der Fügestelle verbleibenden RuAl-Phase, die mechanische Belastbarkeit der Fügestelle erhöht wird. Zweitens zeigen eigene Messungen der Temperatur, dass diese in den Ru/Al-Multischichten Werte oberhalb von mindestens 1850 °C erreichen. In bisherigen Multischichtsystemen sind solche Werte nicht erreicht worden. Im Vergleich zu kommerziell vertriebenen Ni/Al-Nanofoil-Schichten sind die Temperaturen beispielsweise um 400°C höher. Entsprechendes gilt auch für Pulversysteme. Neue Anwendungsfelder für reaktive metallische Systeme können dadurch erschlossen werden. Im Falle der reaktiven Multischichten gemäß der vorliegenden Erfindung können diese zur lokalen Wärmeerzeugung, beispielsweise in der Fertigungstechnik zum großflächigen Fügen zweier metallischer Flächenelemente, verwendet werden. Hierbei ist von Vorteil, daß aufgrund der lokal begrenzten Wärmeerzeugung gegebenenfalls vorhandene benachbarte wärmeempfindliche Bauteile geschont werden. Aufgrund der Tatsache, daß die RuAl-Phase ein exzellenter elektrischer Leiter ist, können die erfindungsgemäßen Multischichten in allen Bereichen Anwendung finden, in denen die elektrische Leitfähigkeit von Bedeutung ist.

Nachfolgend wird die Erfindung anhand von Figuren am Ausführungsbeispiel einer reaktiven Multischicht auf Ru/Al-Basis näher erläutert.

Es zeigen
- Figur 1: die Reaktivität (= H_{f}) und Duktilität (= 1/T_{BD}) untersuchter reaktiver Multischichten,
- Figur 2: eine schematische Darstellung der Prozesse während der Reaktion,
- Figur 3: die Abhängigkeit der Geschwindigkeit von der Multischichtperiode (Summe der Einzelschichtdicken) für selbstausbreitende Reaktionen in binären Ru/Al-Multischichten,
- Figur 4: ein Röntgendiffraktogramm einer Ru/Al-Multischicht nach der Reaktion und
- Figur 5: Temperaturprofile für Ru/Al-Multischichten mit Perioden zwischen 22 und 178 nm.

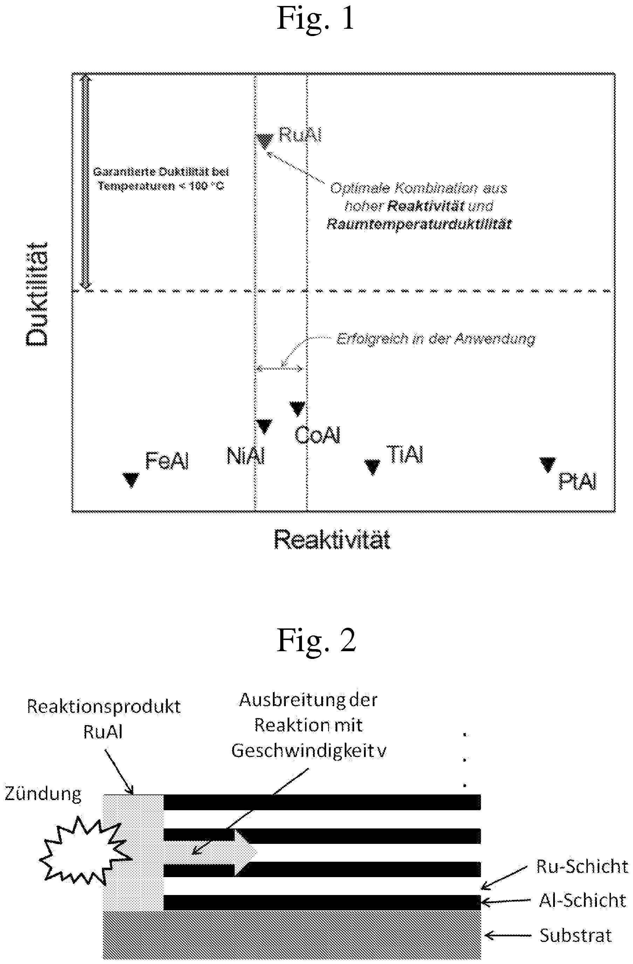

In Fig. 1 sind 1/T_{BD} und H_{f} zur Charakterisierung von Duktilität bzw. Reaktivität gegeneinander aufgetragen. Mit Ni/Al- und Co/Al-Multischichten sind bereits erfolgreich Bauteile gefügt worden. Dieser Bereich der Reaktivität kann somit als ausreichend für die Anwendung betrachtet werden. Unzureichend ist hingegen für beide Systeme die Raumtemperaturduktilität der intermetallischen Aluminide. NiAl und CoAl sind bei Raumtemperatur spröde und durch eine T_{BD} von 400 bzw. 300 °C charakterisiert. Legt man zur Werkstoffoptimierung eine Duktilität bei Temperaturen < 100 °C fest, so wird in Fig. 1 ein Eigenschaftsfenster mit der besten Kombination aus Reaktivität und Raumtemperaturduktilität definiert. Die intermetallische Phase RuAl fällt in dieses Fenster. Sie kombiniert einzigartig eine hohe Reaktivität (H_{f} = 48 kJ/mol) mit einer hohen Raumtemperaturduktilität (T_{BD} < 23 °C). Die Bildungswärme von B2-RuAl ist mit der von NiAl vergleichbar (vgl. Fig. 1).

Somit sind reaktive Ru/Al-Multischichten unter Bildung der B2-Phase RuAl vielversprechend bei der Materialoptimierung von reaktiven metallischen Multischichten.

Anhand von Fig. 2 wird die Erfindung näher beschrieben.

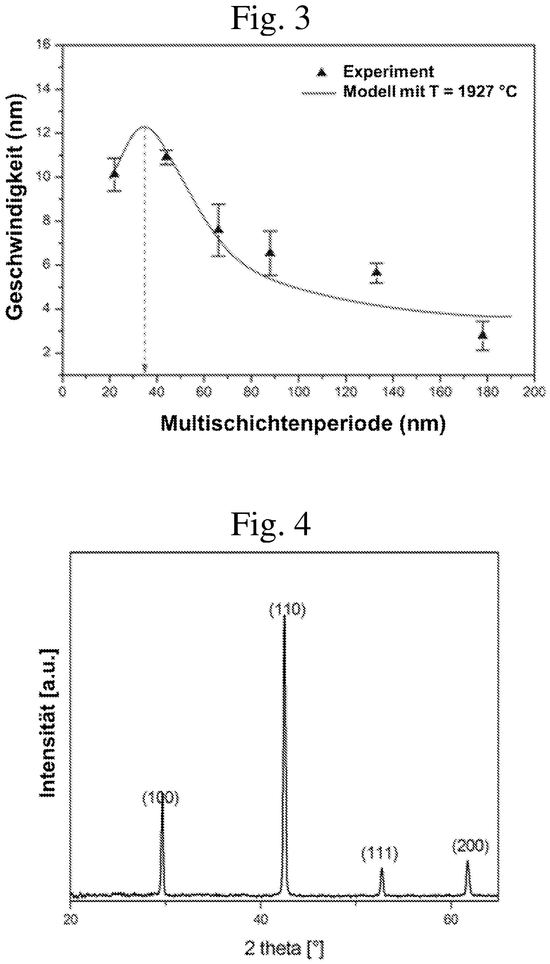

Mittels Dünnschichtmethodik (Methoden der physikalischen oder chemischen Dampfabscheidung) werden sequentiell Ruthenium (Ru)- und Aluminium (Al)-Dünnschichten übereinander auf einem geeigneten Substrat abgeschieden. Die Einzelschichtdicke der Ru- bzw. Al Schichten liegt im Bereich zwischen 10 und 500 nm. Die Gesamtschichtdicke eines solchen Multischichtstapels erreicht Werte bis 1 cm (abhängig von der jeweiligen Anwendung). Anschließend kann die Multischicht von ihrem Substrat entfernt werden. Mittels eines Laserstrahls, Zündfunkens oder per offener Flamme wird die Ru/Al-Multischicht lokal erhitzt und damit die exotherme chemische Reaktion von Ru und Al zu RuAl induziert. Die dadurch freigesetzte Wärme induziert in der direkten Umgebung wiederum die Phasenbildung. Aufgrund von atomarer Diffusion und Wärmetransport breitet sich diese Reaktion parallel zu den Einzelschichten mit Geschwindigkeiten v zwischen 2 und 11 m/s durch die Multischicht aus (vgl. Fig 3).

Durch gezielte Wahl der sogenannten Multischichtperiode, d.h. der Summe der Einzelschichtdicken, können die Reaktionsbedingungen und damit die Geschwindigkeit kontrolliert werden. Das Reaktionsprodukt ist im Falle von binären Ru/Al-Multischichten die intermetallische Phase RuAl. Werden höherkomponentige Systeme auf Ru/Al-Basis verwendet, entstehen entsprechende Legierungen auf RuAl-Basis.

Eigene Untersuchungen mittels Röntgendiffraktion zeigen eindeutig, dass im ersteren Fall tatsächlich die intermetallische Phase RuAl einphasig in den beschriebenen Schichten entstanden ist (vgl. Fig 4). Es sind ausschließlich die Reflexe der RuAl-Phase zu identifizieren.

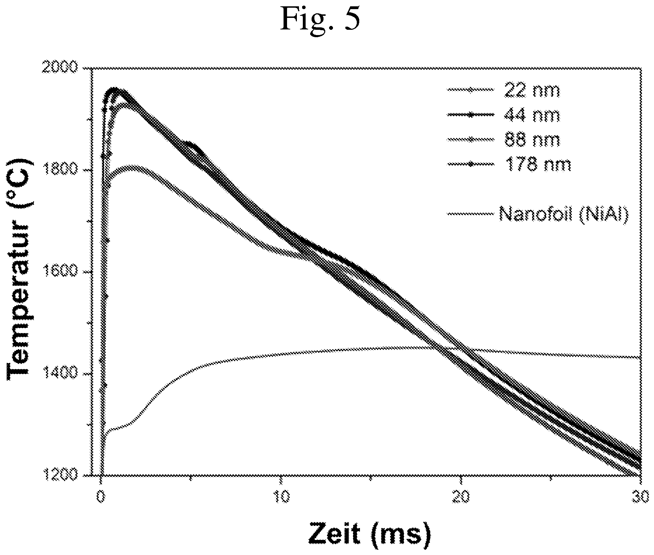

Darüber hinaus belegen eigene Temperaturmessungen mittels Hochgeschwindigkeitspyrometrie, dass während der Reaktion Temperaturen von mindestens 1850 °C erreicht werden (vgl. Fig 5).

Entsprechendes gilt auch für Pulversysteme. Gemeinsames strukturelles Merkmal sind nämlich die kleinen Schichtdicken im Falle der Multischichten bzw. bei einem Pulversystem die Partikelgrößen in ähnlicher Dimension. Dieses strukturelle Charakteristikum erlaubt kurze Diffusionswege zwischen den Reaktionspartnern, sodass die Reaktion zwischen Ruthenium und Aluminium begünstigt wird.

## Patentansprüche

1. Verwendung eines Verfahrens zur lokalen Wärmeerzeugung in der Fertigungstechnik zum großflächigen Fügen zweier metallischer Flächenelemente, wobei sequentiell Ruthenium- bzw. Aluminium-Dünnschichten zur Bildung einer Multischicht übereinander abgeschieden werden, wobei die Einzelschichtdicke der Ruthenium- bzw. der Aluminiumschichten zwischen 10 und 500 nm beträgt und die Multischicht mittels eines Laserstrahls, Zündfunkens oder per offener Flamme lokal erhitzt und eine exotherme Reaktion von Ru und Al zu RuAl induziert wird.

2. Verwendung eines Verfahrens zur lokalen Wärmeerzeugung in der Fertigungstechnik zum großflächigen Fügen zweier metallischer Flächenelemente, wobei Pulver, welches Ruthenium- bzw. Aluminium-Partikel enthält, appliziert wird, wobei die Ruthenium- bzw. der Aluminiumpartikel einen mittleren Durchmesser von 10 bis 100 nm aufweisen und das Pulver mittels eines Laserstrahls, Zündfunkens oder per offener Flamme lokal erhitzt und eine exotherme Reaktion von Ru und Al zu RuAl induziert wird.

3. Verwendung gemäß Anspruch 1, **dadurch gekennzeichnet, dass** das Abscheiden der Ruthenium- bzw. Aluminium-Dünnschichten mittels physikalischer oder chemischer Dampfabscheidung erfolgt.

4. Verwendung gemäß Anspruch 1, **dadurch gekennzeichnet, dass** die sequentiell abgeschiedenen Ruthenium- und Aluminium-Dünnschichten als Multischicht von dem Substrat abgehoben werden.

5. Verwendung gemäß Anspruch 4, **dadurch gekennzeichnet, dass** die Multischicht eine Schichtdicke von bis zu 100 µm aufweist.

6. Verwendung gemäß einem der Ansprüche 1, 3, 4 oder 5, **dadurch gekennzeichnet, daß** aus mehreren Multischichten ein Multischichtstapel gebildet wird.

7. Verwendung gemäß Anspruch 6, **dadurch gekennzeichnet, daß** der Multischichtstapel eine Gesamtschichtdicke von bis zu 1 cm aufweist.

## Claims

1. Use of a method for localized heat generation in production engineering for large-area joining of two metallic surface elements, wherein thin layers of ruthenium and aluminium are deposted sequentially one upon the other to form a multilayer, wherein the individual layer thickness of the ruthenium and of the aluminium layers is between 10 and 500 nm and the multilayer is heated locally by means of a laser beam, an ignition spark or an open flame, inducing an exothermic reaction between Ru and Al to form RuAl.

2. Use of a method for localized heat generation in production engineering for large-area joining of two metallic surface elements, wherein powder containing ruthenium and aluminium particles is applied, wherein the ruthenium and aluminium particles have an average diameter of 10 to 100 nm and the powder is heated locally by means of a laser beam, an ignition spark or an open flame, inducing an exothermic reaction between Ru and Al to form RuAl.

3. Use according to claim 1, **characterised in that** the thin layers of ruthenium and aluminium are deposited by means of physical or chemical vapour deposition.

4. Use according to claim 1, **characterised in that** the sequentially deposited thin layers of ruthenium and aluminium are detached from the substrate as a multilayer structure.

5. Use according to claim 4, **characterised in that** the multilayer structure has a layer thickness of up to 100 µm.

6. Use according to any one of the claims 1, 3, 4 or 5, **characterised in that** a multilayer stack is formed from a plurality of multilayers.

7. Use according to claim 6, **characterised in that** the multilayer stack has an overall thickness of up to 1 cm.

## Revendications

1. Utilisation d'un procédé pour générer localement de la chaleur dans les techniques d'assemblage pour l'assemblage par grande surface de deux éléments métalliques de grande dimension, des couches minces de ruthénium et d'aluminium étant empilées de façon séquentielle pour former une multicouche, l'épaisseur de chaque couche de ruthénium ou d'aluminium respectivement étant comprise entre 10 et 500 nm, et la multicouche étant chauffée localement au moyen d'un rayon laser, d'une étincelle d'allumage ou d'une flamme nue, et une réaction exothermique du Ru et de Al étant induite pour former du RuAI.

2. Utilisation d'un procédé pour générer localement de la chaleur dans les techniques d'assemblage pour l'assemblage par grande surface de deux éléments métalliques de grande dimension, de la poudre contenant des particules de ruthénium ou d'aluminium respectivement étant appliquée, les particules de ruthénium ou d'aluminium respectivement présentant un diamètre moyen de 10 à 100 nm, et la poudre étant chauffée localement au moyen d'un rayon laser, d'une étincelle d'allumage ou d'une flamme nue, et une réaction exothermique du Ru et de Al étant induite pour former du RuAI.

3. Utilisation selon la revendication 1, **caractérisée en ce que** le dépôt des couches minces de ruthénium et d'aluminium respectivement est réalisé par un dépôt en phase vapeur physique ou chimique.

4. Utilisation selon la revendication 1, **caractérisée en ce que** les couches minces de ruthénium et d'aluminium respectivement, déposées de façon séquentielle, sont détachées du substrat sous forme d'une multicouche.

5. Utilisation selon la revendication 4, **caractérisée en ce que** la multicouche présente une épaisseur de couche pouvant atteindre 100 µm.

6. Utilisation selon l'une des revendications 1, 3, 4 ou 5, **caractérisée en ce qu'**une pile multicouche est formée à partir de plusieurs multicouches.

7. Utilisation selon la revendication 6, **caractérisée en ce que** la pile multicouche présente une épaisseur totale pouvant atteindre 1 cm.
